# EUROPEAN PATENT APPLICATION

(11) **EP 1 681 719 A2**
(43) Date of publication of application: **19.07.2006**
(21) Application number: 05077999.0
(22) Date of filing: 27.12.2005
(51) Int. Cl.: H01L 23/58

(54) **Semiconductor device with split pad design**

(30) Priority: 13.01.2005 US 35212
(71) Applicant: Delphi Technologies, Inc., Troy, MI 48007 (US)
(72) Inventor: Campbell, Robert J., Noblesville IN 46060 (US); Hayes, Monty B., Kokomo IN 46902 (US); Fruth, John R., Kokomo IN 46901 (US)
(74) Representative: Denton, Michael John

(57) **Abstract**

A semiconductor device (300) includes a device body (302), a pad (304) and a signal distribution runner (306,308). The device body (302) includes a plurality of parallel cells and at least one integrated electronic component. The pad (304) is located on a surface of the device body (302) and includes a first portion (304A) and a second portion (304B) that are electrically isolated. The signal distribution runner (306,308) is electrically coupled to and extends from the first portion (304A) of the pad (304). The signal distribution runner (306,308) provides a signal to a same terminal of each of the plurality of parallel cells. The at least one integrated electronic component is electrically coupled to the second portion (304B) of the pad (304).

## Description

### TECHNICAL FIELD

The present invention is generally directed to a semiconductor device and, more specifically, to a semiconductor device with a split pad design.

### BACKGROUND OF THE INVENTION

Conventional metal-oxide semiconductor field-effect transistor (MOSFET) and insulated-gate bipolar-transistor (IGBT) power devices have usually been designed with a cellular structure, which includes thousands of elementary cells integrated within a semiconductor die. Each cell has included a transistor, which is connected in parallel to the transistors of the other cells to contribute to an overall current associated with the power device. In general, each cell includes a gate region, which is covered by a thin electrically insulative layer, e.g., a gate oxide layer. The gates of the cells are interconnected with a conductor, e.g., a polysilicon or metal layer, that is formed on a surface of the device. The remaining surface of a MOSFET semiconductor device is typically covered by another conductor, which contacts and interconnects the source region of all of the cells. In general, the cellular structure allows for the achievement of relatively low voltage drop across the power device, i.e., low drain-to-source resistance, when it is in the on-state and, thus, relatively low power dissipation for the power device.

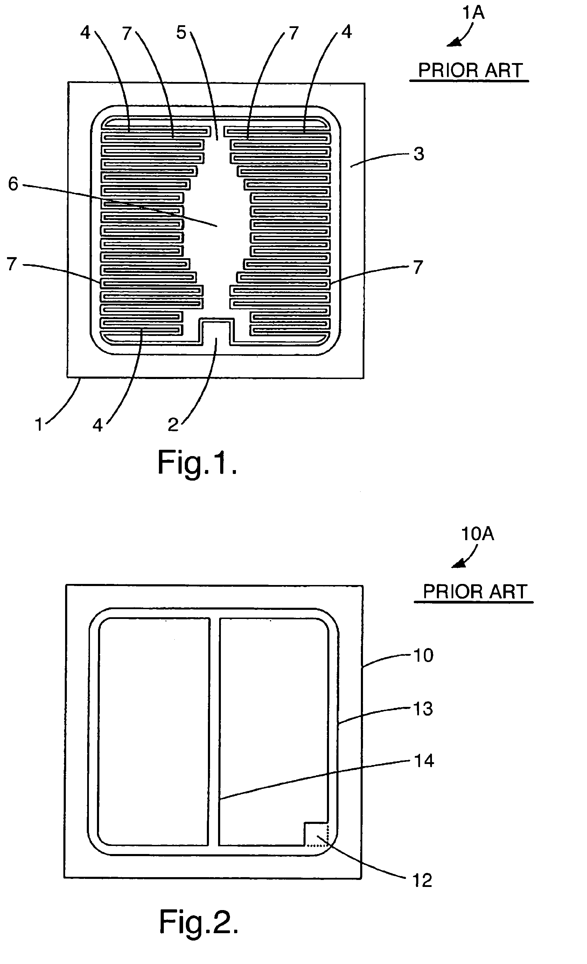

With reference to Fig. 1, a relevant portion of an exemplary prior art MOSFET semiconductor device 1A is illustrated. The device 1A includes a substrate or device body 1, which includes a plurality of cells formed therein. As is shown, a conductive gate pad 2 is centrally located along one edge of the substrate 1 and is connected to a conductive gate signal ring 3 that extends along a periphery of the substrate 1. Extending from the ring 3 are a plurality of conductive gate signal fingers 4, which are utilized provide a gate signal to a gate region of each of the cells. A conductive source plate 5 includes a central pad area 6 with source fingers 7 providing electrical connection to a source of each of the cells.

In semiconductor devices that have implemented solder connections, at least one such device has located a gate pad in a corner of the device. With reference to Fig. 2, a semiconductor device 10A with a gate pad 12 located at a corner of a device body 10 is shown. In this illustration, the source metallization is not shown. As is depicted, a gate signal ring 13 traverses the periphery of the device body 10 with an interconnected gate finger 14 traversing through a center of the device body 10 and connecting halves of the gate signal ring 13.

In general, designers have attempted to design gate signal ring and fingers to allow parallel cells within a semiconductor device to turn on and off with minimal propagation delay between the cells and to allow current to flow in a uniform manner across the power device. The gate signal runners have been made of a variety of materials, e.g., metals, polysilicon or a combination of metal and polysilicon, and have had various configurations depending on the physical dimensions and operating frequency of the device. For devices operating at lower frequencies, a relatively simple gate structure that traverses the periphery of the device has generally been suitable. However, devices operating at higher frequencies have generally required additional gate fingers (see Fig. 1) to allow for uniform propagation of the gate signal from a gate pad of the device to all of the parallel cells.

Gate pads have usually been centered along one of the edges of the semiconductor device or located at a center of the device. In a typical semiconductor device that implements wire bonding, the gate pad provides an interconnect point between the cells of the device and an external lead or device. Frequently, MOSFET (IGBT) devices are interconnected to external circuitry by soldering the drain (collector) and wire bonding the gate and source (gate and emitter) to other interconnects. Other solderable MOSFET devices, such as flip-chip devices, have been configured to allow for drain, source and gate interconnects to be achieved with a solder connection. Similarly, IGBT devices have been constructed such that collector, gate and emitter connections are made through a solder connection.

In many MOSFET semiconductor designs, it is desirable to integrate electronic components, such as resistors, zener diodes or conventional diodes from the gate to the source or from the gate to the drain. In IGBT semiconductor designs, electronic components are typically integrated from the gate to emitter or from the gate to the collector. In general, such components provide control or protection functions for an associated power device. In smart power devices, additional complex logic or driver circuitry may be integrated within the semiconductor device and be connected to various input/output pads to provide added functionality. Unfortunately, the addition of the integrated electronic components and circuitry to the gate of a semiconductor device can affect testing of the semiconductor device. For example, leakage current tests, gate stress tests, avalanche tests and energy tests of the semiconductor device may be adversely affected, when integrated electronic components are coupled to the gate of the device. While the previously mentioned tests may be omitted on semiconductor devices that include integrated components and other circuitry, omitting the tests may allow semiconductor devices with high gate leakage currents or latent defects to be placed in a production electronic product that may then experience premature failure in the field.

What is needed is a technique that allows semiconductor devices that include a device body including a plurality of parallel cells and at least one integrated electronic component to be tested without the test results associated with the plurality of parallel cells being adversely affected by the at least one integrated electronic component.

### SUMMARY OF THE INVENTION

According to one embodiment of the present invention, a semiconductor device is provided that includes a device body, a gate pad and a gate signal distribution runner. The device body includes a plurality of parallel cells and at least one integrated electronic component. The gate pad is located on a surface of the device body and includes a first portion and a second portion that are electrically isolated. The gate signal distribution runner is electrically coupled to and extends from the first portion of the gate pad. The gate signal distribution runner provides a gate signal to a gate of each of the plurality of parallel cells. In order to provide additional electronic components without affecting the testing of the device, at least one integrated electronic component is electrically coupled to the second portion of the gate pad.

According to another aspect of the present invention, the plurality of parallel cells defines a metal-oxide semiconductor field-effect transistor (MOSFET). According to a different aspect of the present invention, the plurality of parallel cells defines an insulated-gate bipolar-junction transistor (IGBT). According to another embodiment of the present invention, the gate signal distribution runner is made of one of a metal and a polysilicon. According to another aspect, the metal is aluminum. According to a different aspect, the integrated electronic component includes at least one of a resistor, a diode and a zener diode. According to another embodiment, the first and second portions of the gate pad are electrically interconnected after testing of the parallel cells.

According to another aspect of the present invention, a semiconductor device includes a device body, a pad and a signal distribution runner. The device body includes a plurality of parallel cells and at least one integrated electronic component. The pad is located on a surface of the device body and includes a first portion and a second portion that are electrically isolated. The signal distribution runner is electrically coupled to and extends from the first portion of the pad. The signal distribution runner provides a signal to a same terminal of each of the plurality of parallel cells. In order to provide additional electronic components without affecting the testing of the device, at least one integrated electronic component is electrically coupled to the second portion of the pad.

These and other features, advantages and objects of the present invention will be further understood and appreciated by those skilled in the art by reference to the following specification, claims and appended drawings.

### BRIEF DESCRIPTION OF THE DRAWINGS

The present invention will now be described, by way of example, with reference to the accompanying drawings, in which:
Fig. 1 is top view of a relevant portion of an exemplary semiconductor device, with a gate pad, configured according to the prior art;
Fig. 2 is top view of a relevant portion of another exemplary semiconductor device, with a gate pad, configured according to the prior art;
Fig. 3 is top view of an exemplary semiconductor device, with a gate pad, configured according to one embodiment of the present invention;
Figs. 4A-4C are top perspective views of gate pads designed, according to different embodiments of the present invention;
Fig. 4D is a perspective view of the pad of Fig. 4C, with the portions of the pad electrically coupled by a wire after a wire bond process;
Figs. 5A-5B are electrical schematics of an exemplary metal-oxide semiconductor field-effect transistor (MOSFET) devices, including different exemplary electronic components coupled between a second portion of a gate pad and a source; and
Figs. 5C-5D are electrical schematics of an exemplary insulated-gate bipolar-junction transistor (IGBT) devices, including different exemplary electronic components coupled between a first portion of a gate pad and a collector and a first portion of a gate pad and a collector and a second portion of a gate pad and an emitter, respectively.

### DESCRIPTION OF THE PREFERRED EMBODIMENTS

As is noted above, in power metal-oxide semiconductor field-effect transistor (MOSFET) devices and/or insulated-gate bipolar-junction transistor (IGBT) devices, gate pad and gate signal distribution runners are utilized to provide gate signal distribution to a plurality of parallel cells of the devices. The distribution of the gate signal controls the turn-on and turn-off characteristics of the device. In a typical prior art device, the gate pad has been a single metalized pad, which has been connected to an external package pin by a wire bond or solder interconnect. However, as is noted above, in many semiconductor designs, it is desirable to integrate other electronic components, e.g., resistors, zener diodes or conventional diodes, from the gate to source or from the gate to drain for a MOSFET device, or from the gate to emitter or from the gate to the collector for an IGBT device.

These integrated electronic components may provide control or protection functions for the power device. As is also noted above, in smart power devices, additional complex logic or driver circuitry may be integrated within the device and be connected to various input/output pads to provide additional functionality. As noted above, the addition of the integrated electronic components and circuitry to the gate of the device affects the ability of a test engineer to accurately determine device characteristics, such as current leakage, gate stress and avalanche and also affects energy tests performed on the device.

According to the present invention, in order to provide accurate useful results for various tests, the gate pad of the semiconductor device is partitioned to allow the semiconductor device to be tested, without the additional electronic components. According to the present invention, the pads are rejoined after testing such that the integrated electronic components are connected to the plurality of parallel cells that form the semiconductor device. As is discussed further below, the electronic components may be added back into the circuit through soldering the partitioned gate pad together or wire bonding the partitioned gate pad together during the wire bonding process.

In general, the present invention is applicable to the semiconductor devices that have top-side solderable or wire-bonded gate connections. It should be appreciated that a semiconductor device configured in this manner can be tested at the wafer level or at a die level using standard probe cards. In this manner, the probe cards and the tester hardware allow the various resistors, conventional diodes and/or zener diodes to be switched into or out of the circuit, thus, allowing full functional and parametric tests to occur at a wafer level. Further, special tests, such as gate level stress tests, energy tests and avalanche tests can also be performed without the test results being affected by the additional electronic components. When the semiconductor device is assembled into its package or system, the two or more split gate areas are then connected together through a solder connection or a wire bond.

It should be appreciated that a large variety of split gate options are possible. In general, the edge patterns of the various portions of the gate pad may be optimized to ensure proper bridging during the solder reflow or wire bond process. The present invention is also generally applicable to any input or output integrated circuit pad that has circuitry or protection devices attached to it that would adversely affect testing of the device. It should be appreciated that testing the integrated circuit (IC) with the option of switching circuitry in or out at the wafer level may also be generally desirable.

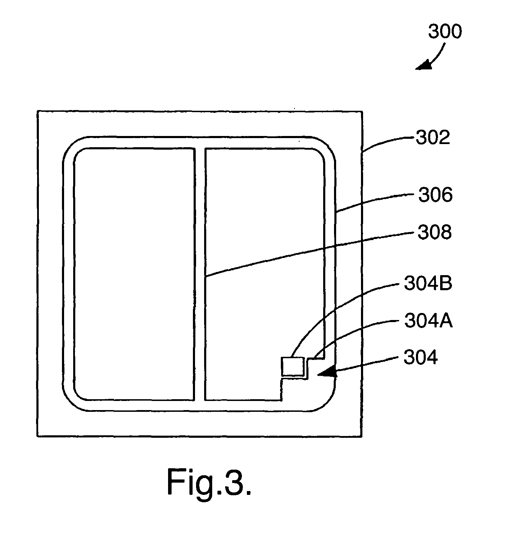

As is also shown in Fig. 3, gate pad 304 of semiconductor device 300 is split into portions 304A and 304B. The portion 304B is coupled to at least one integrated electronic component (not shown in Fig. 3), which may, for example, include a resistor, conventional diode or zener diode. The semiconductor device 300 includes a device body 302 that has integrated therein a plurality of parallel cells (not shown), whose gates are coupled to the portion 304A of the gate pad 304 by peripheral gate runner 306 and middle gate runner 308. When the portion 304A is interconnected to the portion 304B, the electronic components connected to the portion 304B are connected between the devices gate and source (for a MOSFET) or gate to emitter or gate to collector for an IGBT. As is discussed above, when the portions 304A and 304B are electrically isolated, full and complete device testing can occur. Further, when the portions 304A and 304B are electrically interconnected, the semiconductor device 300 is protected from transients and/or other circuitry integrated within the device body 302 is functional.

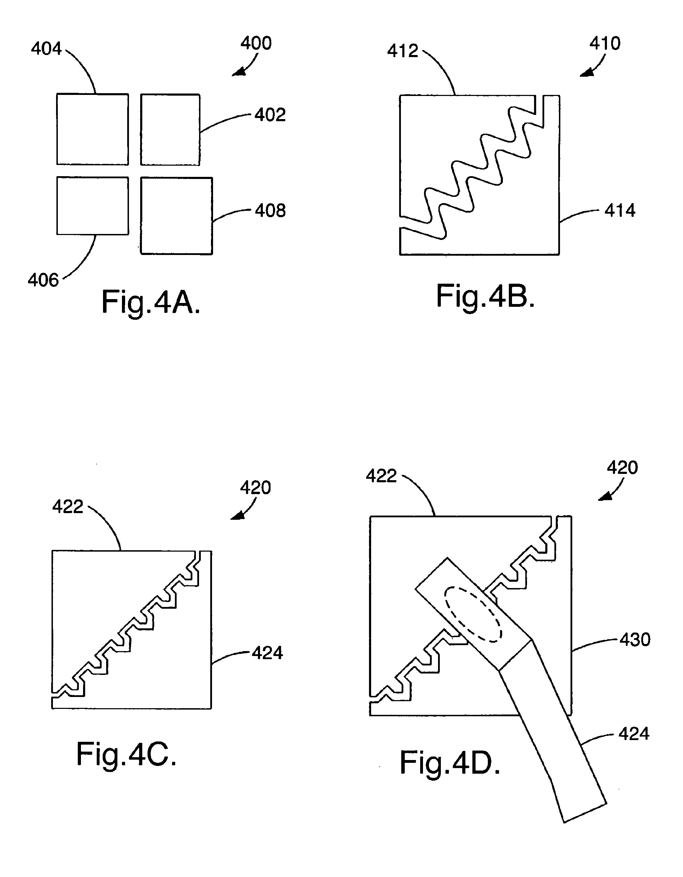

Fig. 4A shows an exemplary gate pad 400 that includes portions 402, 404, 406 and 408. It should be appreciated that one of the portions, e.g., portion 408, is coupled to gate runners to provide a gate signal to a plurality of parallel cells integrated in a device body of an associated semiconductor. Fig. 4B shows an exemplary gate pad 410 that includes portions 412 and 414, one of which would be connected to a gate of each of the plurality of parallel cells. Fig. 4C shows another exemplary gate pad 420, including portions 422 and 424, one of which is connected to the gate of a plurality of cells and the other of which is connected to at least one integrated electronic component. Fig. 4D shows the pad 420 of Fig. 4C with the portions 422 and 424 interconnected by a wire 430 through a wire bonding process.

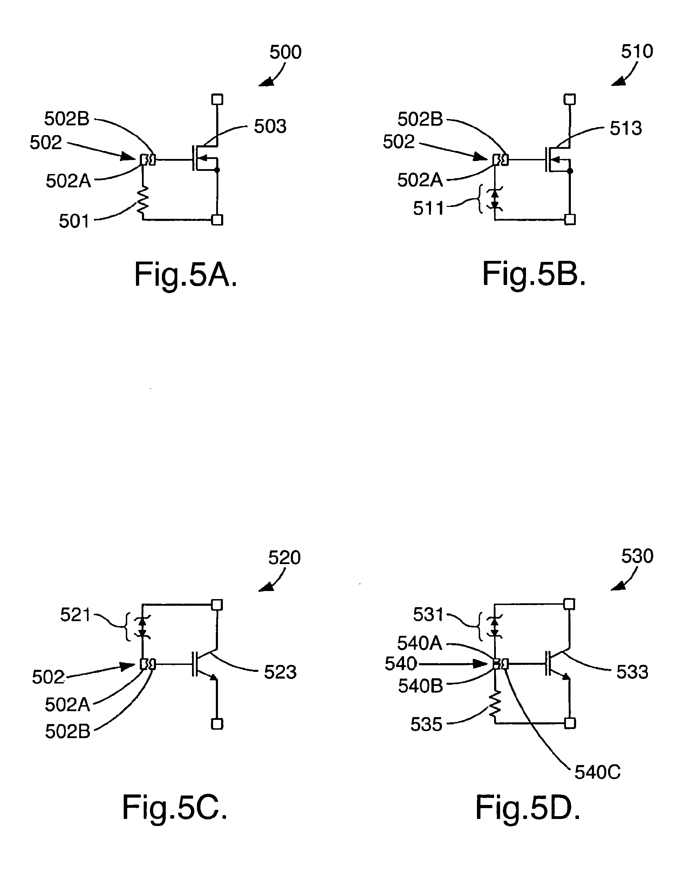

Fig. 5A is an electrical schematic of a semiconductor device 500 that includes a MOSFET 503 and an integrated electronic component 501, e.g., a resistor. As is shown in Fig. 5A, the resistor 501 is coupled between a first portion 502A of gate pad 502 and a source of the MOSFET 503. A gate of the MOSFET 503 is coupled to a second portion 502B of the gate pad 502. Fig. 5B is an electrical schematic of a device 510 that is similar to the device 500 of Fig. 5A, with the exception that a pair of zener diodes 511 are coupled between the first portion 502A of the gate pad 502 and a source of a FET 513. Fig. 5C is an electrical schematic of a semiconductor device 520 that includes an insulated-gate bipolar-junction transistor (IGBT) 523, whose gate is coupled to the second portion 502B of the gate pad 502. A pair of zener diodes 521 are coupled between the first portion 502A of the gate pad 502 and a collector of a IGBT 523.

Fig. 5D is an electrical schematic of a semiconductor device 530 that is similar to the semiconductor device 520 of Fig. 5C, with the exception that a gate pad 540 is divided into three portions, 540A, 540B and 540C. As is shown in Fig. 5D, a pair of zener diodes 531 are coupled between a first portion 540A of the gate pad 540 and a collector of a IGBT 533. A resistor 535 is coupled between a second portion 540B of the gate pad 540 and an emitter of the IGBT 533. A gate of the IGBT 533 is coupled to a third portion 540C of the gate pad 540. As is discussed above, after testing, the various portions of the gate pads 502 (540) of the semiconductor devices 500, 510 and 520 (530) are electrically interconnected.

Accordingly, a semiconductor device with a split pad design has been disclosed herein that advantageously allows for testing of a primary semiconductor device without the test results being affected by an integrated electronic component that is included in the semiconductor device.

The above description is considered that of the preferred embodiments only. Modifications of the invention will occur to those skilled in the art and to those who make or use the invention. Therefore, it is understood that the embodiments shown in the drawings and described above are merely for illustrative purposes and not intended to limit the scope of the invention, which is defined by the following claims as interpreted according to the principles of patent law, including the doctrine of equivalents.

## Claims

1. A semiconductor device (300), comprising:
a device body (302) including a plurality of parallel cells and at least one integrated electronic component;
a gate pad (304) located on a surface of the device body (302), wherein the gate pad includes a first portion (304A) and a second portion (304B) that are electrically isolated; and
a gate signal distribution runner (306,308) electrically coupled to and extending from the first portion (304A) of the gate pad (304), wherein the gate signal distribution runner (306,308) provides a gate signal to a gate of each of the plurality of parallel cells, and wherein the at least one integrated electronic component is electrically coupled to the second portion (304B) of the gate pad (304).

2. The semiconductor device (300) of claim 1, wherein the plurality of parallel cells defines a metal-oxide semiconductor field-effect transistor (MOSFET).

3. The semiconductor device (300) of claim 1, wherein the plurality of parallel cells defines an insulated-gate bipolar-junction transistor (IGBT).

4. The semiconductor device (300) of claim 1, wherein the runner (306,308) is made of one of a metal and a polysilicon.

5. The semiconductor device (300) of claim 4, wherein the metal is aluminum.

6. The semiconductor device (300) of claim 1, wherein the integrated electronic component includes at least one of a resistor, a diode and a zener diode.

7. The semiconductor device (300) of claim 1, wherein the first and second portions (304A,304B) of the gate pad (304) are electrically interconnected after testing of the parallel cells.

8. A metal-oxide semiconductor field-effect transistor (MOSFET) (300), comprising:
a device body (302) including a plurality of parallel cells and at least one integrated electronic component;
a gate pad (304) located on a surface of the device body (302), wherein the gate pad (304) includes a first portion (304A) and a second portion (304B) that are electrically isolated; and
a gate signal distribution runner (306,308) electrically coupled to and extending from the first portion (304A) of the gate pad (304), wherein the gate signal distribution runner (306,308) provides a gate signal to a gate of each of the plurality of parallel cells, and wherein the at least one integrated electronic component is electrically coupled to the second portion (304B) of the gate pad (304).

9. The MOSFET (300) of claim 8, wherein the runner (306,308) is made of one of a metal and a polysilicon.

10. The MOSFET (300) of claim 9, wherein the metal is aluminum.

11. The MOSFET (300) of claim 8, wherein the integrated electronic component includes at least one of a resistor, a diode and a zener diode.

12. The MOSFET (300) of claim 8, wherein the first and second portions (304A,304B) of the gate pad (304) are electrically interconnected after testing of the parallel cells.

13. The MOSFET (300) of claim 12, wherein the first and second portions (304A, 304B) of the gate pad (304) are electrically interconnected with a wire bond.

14. The MOSFET (300) of claim 12, wherein the first and second portions (304A, 304B) of the gate pad (304) are electrically interconnected with solder.

15. A insulated-gate bipolar-junction transistor (IGBT) (300), comprising:
a device body (302) including a plurality of parallel cells and at least one integrated electronic component;
a gate pad (304) located on a surface of the device body (302), wherein the gate pad (304) includes a first portion (304A) and a second portion (304B) that are electrically isolated; and
a gate signal distribution runner (306,308) electrically coupled to and extending from the first portion (304A) of the gate pad (304), wherein the gate signal distribution runner (306,308) provides a gate signal to a gate of each of the plurality of parallel cells, and wherein the at least one integrated electronic component is electrically coupled to the second portion (304B) of the gate pad (304).

16. The IGBT (300) of claim 15, wherein the runner (306,308) is made of one of a metal and a polysilicon.

17. The IGBT (300) of claim 16, wherein the metal is aluminum.

18. The IGBT (300) of claim 15, wherein the integrated electronic component includes at least one of a resistor, a diode and a zener diode.

19. The IGBT (300) of claim 15, wherein the first and second portions (304A,304B) of the gate pad (304) are electrically interconnected after testing of the parallel cells.

20. The IGBT (300) of claim 19, wherein the first and second portions (304A,304B) of the gate pad (304) are electrically interconnected with one of a wire bond and a solder.

21. A semiconductor device (300), comprising:
a device body (302) including a plurality of parallel cells and at least one integrated electronic component;
a pad (304) located on a surface of the device body (302), wherein the pad (304) includes a first portion (304A) and a second portion (304B) that are electrically isolated; and
a signal distribution runner (306,308) electrically coupled to and extending from the first portion (304A) of the pad (304), wherein the signal distribution runner (306,308) provides a signal to a same terminal of each of the plurality of parallel cells, and wherein the at least one integrated electronic component is electrically coupled to the second portion (304B) of the pad (304).
